Europäisches Patentamt

European Patent Office

Office européen des brevets

(11) Numéro de publication: **0 341 156**

**A1**

(12) **DEMANDE DE BREVET EUROPEEN**

(21) Numéro de dépôt: **89401255.8**

(22) Date de dépôt: **03.05.89**

(51) Int. Cl.4: **H 01 L 21/00**
**G 01 R 1/04**

(30) Priorité: **06.05.88 FR 8806153**

(43) Date de publication de la demande:
**08.11.89 Bulletin 89/45**

(84) Etats contractants désignés: **DE GB IT**

(71) Demandeur: **SOCIETE D'APPLICATIONS GENERALES D'ELECTRICITE ET DE MECANIQUE SAGEM**
**6, Avenue d'Iéna**
**F-75783 Paris Cédex 16 (FR)**

(72) Inventeur: **Galian, François**
**83, Avenue du Chateau**
**F-77340 Pontault-Combault (FR)**

**Feuillioux, André**
**38, rue Christophe Thivrier**
**F-03100 Montlucon (FR)**

(74) Mandataire: **Gorree, Jean-Michel et al**
**Cabinet Plasseraud 84, rue d'Amsterdam**
**F-75009 Paris (FR)**

(54) **Dispositif de support et de régulation thermique d'une pièce et appareillage de test de plaques de circuits semi-conducteurs incluant un tel dispositif.**

(57) Dispositif (1) pour, par simple contact, supporter et maintenir en position une pièce et porter celle-ci à une température souhaitée négative ou positive, le maintien de la pièce s'effectuant par effet de dépression, comprenant : un plateau (2) thermiquement conducteur avec une face supérieure (7) possédant au moins une gorge (8) en communication avec un conduit (9, 10) de raccordement avec une source de gaz en dépression, des enceintes parallèles (15) prévues dans le plateau (2) et traversées par des flux de fluide de réglage thermique à la susdite température souhaitée positive ou négative ; et une chambre périphérique (16) entourant le plateau (2) et contenant un gaz sec sous pression distribué par des moyens de sortie (18) répartis périphériquement et orientés vers le centre du plateau de manière que le gaz sec soit dirigé au-dessus de la surface du plateau et sur la pièce supportée par celui-ci afin d'empêcher la formation de condensation et de givre pour des températures basses.

FIG. 2.

EP 0 341 156 A1

## Description

## Dispositif de support et de régulation thermique d'une pièce et appareillage de test de plaques de circuits semi-conducteurs incluant un tel dispositif.

La présente invention concerne un dispositif pour, par simple contact, supporter et maintenir une pièce en position et porter celle-ci à une température souhaitée, négative ou positive. L'invention concerne aussi un appareillage de test de plaques de circuits semi-conducteurs qui inclut un tel dispositif.

Les pastilles ou puces de circuits semi-conducteurs, notamment de circuits intégrés, sont obtenues par découpe d'une plaque primaire (ou "wafer") sur laquelle sont formés simultanément une grande quantité de circuits identiques. Etant donné les dimensions très réduites des puces et les difficultés de manipulation qui en résultent, il est apparu plus avantageux de tester les puces non pas sous forme individuelle après découpe, mais directement sur la plaque (ou "wafer") elle-même ; un système de repérage permet d'identifier chaque puce de la plaque et les puces révélées défectueuses (hors normes) par le test sont éliminées après découpe de la plaque.

Ce processus est avantageux car il permet l'élimination des puces défectueuses dès leur fabrication et avant les opérations ultérieures (notamment leur encapsulage), d'où une économie sensible dans la fabrication. En outre, ce processus permet d'envisager un contrôle systématique et automatique de toutes les puces fabriquées, d'où un gros avantage pour l'utilisateur qui est pratiquement assuré de n'acheter que des composants en état de fonctionnement, alors que jusqu'à présent aucun contrôle systématique n'était effectué et que, si un contrôle préalable était souhaité, il était réalisé manuellement avec une augmentation considérable du coût des composants sélectionnés.

Toutefois, le contrôle systématique tel qu'il peut être pratiqué actuellement présente quelques inconvénients en raison des insuffisances du matériel utilisé.

Le brevet U.S. 4 491 173 montre un dispositif du genre concerné par l'invention adapté pour le support de plaques de circuits semi-conducteurs.

Un premier inconvénient de ce dispositif connu réside dans les moyens de maintien de la plaque à circuits semi-conducteurs sur le plateau du dispositif. Si les moyens à dépression d'air semblent bien appropriés (des moyens mécaniques de saisie et de blocage de la plaque endommageraient celle-ci en raison de son extrême fragilité), par contre le plateau supérieur muni d'une pluralité de trous (type passoire) impose une limitation dans les dimensions des plaques à tester qui doivent obligatoirement être de suffisamment grandes dimensions pour recouvrir et obturer l'ensemble des trous ; en pratique ce type de dispositif est limité à une seule dimension de plaque. Du fait que les plaques sont en réalité produites avec des formats fort divers variant du simple au double (par exemple avec des diamètres d'environ 75 mm à 150 mm), il serait nécessaire de disposer de plusieurs dispositifs ayant chacun un diamètre (ou une dimension) de plateau adapté à un type de plaque particulier, ce qui accroîtrait considérablement le coût de l'installation et réduirait sa souplesse d'utilisation.

Par ailleurs, le dispositif connu de par ce brevet américain est équipé de bobines de chauffage permettant de chauffer le plateau et, par conduction, la plaque à circuits intégrés jusqu'à une température présélectionnée de manière à permettre le test des puces dans le domaine des hautes températures. Toutefois, cet agencement présente un premier inconvénient fondamental qui est de limiter l'excursion thermique aux plages chaudes, sans possibilité d'explorer les plages froides, alors que les normes de fonctionnement des composants semi-conducteurs prévoient leur emploi à basses températures (par exemple jusqu'à -55°C, voire -65°C) et qu'il est connu que les défectuosités d'une puce peuvent n'apparaître que dans une plage thermique déterminée. Un second inconvénient fondamental de cet agencement connu réside dans la présence des bobines électriques de chauffage dont le courant d'alimentation perturbe par son rayonnement le fonctionnement des puces qui sont parcourues par des courants très faibles et rend les tests inefficaces.

L'invention a donc essentiellement pour but de remédier aux inconvénients ci-dessus exposés et de proposer des moyens perfectionnés qui donnent mieux satisfaction aux diverses exigences de la technique, et en particulier de proposer un dispositif de maintien de pièces sans contact qui accepte des pièces de formats divers, qui soit agencé pour pouvoir porter les pièces aussi bien à des températures positives que négatives, qui soit structurellement agencé pour ne pas perturber le fonctionnement d'appareils avoisinants, qui soit de conception et de structure simples et aussi peu coûteuses que possible, et par ailleurs de proposer un appareillage de test de plaques de circuits semi-conducteurs qui permette un test automatique complet et fiable des puces semi-conductrices.

A ces fins, un premier aspect de l'invention porte sur un dispositif pour, par simple contact, supporter et maintenir en position une pièce et porter celle-ci à une température souhaitée négative ou positive, le maintien de la pièce s'effectuant par effet de dépression qui, selon l'invention, se caractérise essentiellement en ce qu'il comprend :
- un plateau en un matériau thermiquement bon conducteur, et présentant une face supérieure apte à recevoir la pièce précitée, cette face possédant au moins une gorge en communication avec un conduit de raccordement avec une source de gaz en dépression,
- un ensemble d'enceintes prévues dans le plateau et approximativement parallèles les unes aux autres, ces enceintes étant agencées pour être traversées respectivement par des flux de fluide de réglage thermique à la susdite température souhaitée positive ou négative et étant en communication avec des conduits d'arrivée et de sortie de fluide raccordés à une source de fluide de réglage thermique,
- et une chambre périphérique entourant le plateau et contenant un gaz sec sous pression, ladite chambre périphérique comportant un conduit de raccordement à une source d'air sec sous pression et des moyens de passages de sortie répartis sur le pourtour du plateau, débouchant au niveau du plateau et orientés vers le centre du plateau de manière que le gaz sec soit dirigé au-dessus de la surface du plateau et sur la pièce supportée par celui-ci afin d'empêcher la formation de condensation et de givre pour des températures basses.

Avantageusement, les enceintes sont fermées sur elles-mêmes, concentriques et alimentées en parallèles. Dans ce cas, on peut prévoir que des conduits d'arrivée et de sortie du fluide de réglage thermique s'étendent sous les enceintes et communiquent par des passages respectifs avec lesdites enceintes. Pour favoriser l'obtention rapide d'un équilibre thermique, il est intéressant que les conduits d'arrivée et de sortie de fluide soient raccordés aux enceintes de manière telle que ce fluide circule dans des sens opposés dans deux enceintes contiguës. On peut aussi faire en sorte que les enceintes possèdent des sections transversales différentes et croissantes en fonction de leur éloignement du centre du plateau.

Pour améliorer la conduction thermique entre le dispositif et la pièce qu'il supporte et pour que celle-ci soit amenée rapidement et de façon homogène à la température souhaitée, et aussi lorsque les pièces supportées par le dispositif doivent être raccordées électriquement à des organes extérieurs et que la surface des pièces en contact avec le dispositif est elle-même à la masse électrique, il est souhaitable que le plateau soit en un matériau électriquement bon conducteur et soit raccordé à une masse électrique ; en particulier, il est avantageux que le plateau soit en cuivre massif, en un alliage de cuivre ou en aluminium ; pour éviter une oxydation de la surface du plateau et conserver un bon contact de transfert thermique et électrique avec la pièce, on peut prévoir que la face supérieure du plateau soit munie d'un revêtement en or. Dans le cas particulier du test des puces d'une plaque à circuits semi-conducteurs, on est ainsi assuré que toutes les puces possèdent la même masse et on élimine les éventuels problèmes dus à l'électricité statique (qui pourrait éventuellement endommager ou détruire les puces).

Pour que le dispositif soit adapté à accepter des pièces de différentes dimensions, il est souhaitable de prévoir que la face supérieure du plateau soit munie de plusieurs gorges s'étendant respectivement selon des contours fermés ou presque fermés et raccordées indépendamment les unes des autres à une source de fluide.

Au moins pour des applications particulières, la fabrication du dispositif se trouve simplifiée si le plateau est de forme générale ronde, si les gorges s'étendent selon des contours circulaires fermés ou presque fermés sensiblement concentriques et si les enceintes sont annulaires et concentriques.

La mise en place du dispositif au sein d'un appareillage peut se trouver grandement simplifiée si les divers conduits précités sont creusés au sein du plateau et sont regroupés au voisinage les uns des autres.

Dans un mode de réalisation préféré, le dispositif comprend aussi un carter en forme de cuvette supportant le plateau ; des moyens de support et de positionnement en un matériau électriquement et thermiquement isolant (tel que des cales isolantes et une matière de remplissage injectée) sont interposés entre le carter et le plateau de manière qu'il n'y ait pas de contact entre le carter et le plateau ; et la chambre périphérique de distribution du gaz sec sous pression est alors supportée par le carter.

En outre, le dispositif peut avantageusement comporter un couvercle annulaire évidé centralement qui coiffe le plateau et qui est configuré pour contribuer à diriger le gaz sec vers la surface supérieure du plateau.

Lorsqu'un positionnement précis du dispositif par rapport à d'autres organes est souhaité (par exemple pour obtenir un positionnement correct d'une plaque à circuits semi-conducteurs sous une tête porte-contacts dans un appareillage de test), on peut prévoir que la face inférieure du carter soit rectifiée de manière qu'elle puisse constituer une référence de positionnement vertical de la surface supérieure du plateau.

Enfin, toujours dans le but d'éviter un dépôt d'humidité sur la pièce supportée par le dispositif et le givrage de cette pièce, il est souhaitable de prévoir, en au moins une zone de la périphérie du dispositif, un échangeur thermique parcouru par un fluide froid ou chaud et constituant un capteur de l'humidité contenue dans l'atmosphère avoisinant le plateau.

Le dispositif qui vient d'être décrit peut trouver une application dans de nombreux domaines. Toutefois, conformément à un second aspect de l'invention, une application particulièrement intéressante réside dans la réalisation d'un appareillage de test de plaques de circuits semi-conducteurs qui est équipé d'un tel dispositif.

Dans un mode de réalisation préféré, la tête porte-contacts de l'appareillage de test, qui doit être mise au contact de chaque puce de la plaque et établir avec celle-ci des contacts électriques appropriés pour le test, est fixe et le dispositif de l'invention est alors monté à pivotement autour d'un axe central et est en outre déplaçable selon trois axes de déplacement mutuellement orthogonaux, de manière que chaque puce de la plaque puisse être amenée dans une position prédéterminée précise sous la tête porte-contacts.

Un appareillage conforme à l'invention est agencé pour permettre le fonctionnement approprié du dispositif précité et comporte notamment, dans ce but, une unité de fourniture de fluide de réglage de température porté à une température souhaitée, cette unité comportant un bloc de réfrigération de fluide abaissant la température du fluide à la température minimale de fonctionnement de l'appareillage, puis un bloc de réchauffement de fluide agencé pour réchauffer le fluide jusqu'à une température présélectionnable. Pour que l'appareil permette un test fiable et utile, il doit permettre de tester les puces dans des conditions extrêmes de températures : il est souhaitable que la température de test soit sélectionnable entre -65°C et +210°C.

En outre, l'appareillage comporte avantageusement une unité de fourniture d'un gaz sec incluant un bloc de séchage de gaz qui peut éventuellement être suivi d'un bloc d'ionisation du gaz sec, ce gaz sec étant destiné à être soufflé sur la plaque à circuits semi-conducteurs pour éviter la formation de condensation et de givre sur cette plaque lors des essais sous température négative ; l'ionisation éventuelle de ce gaz sec permet d'éviter la formation d'électricité statique qui perturberait les mesures, et risquerait même d'endommager, voir détruire les puces.

Il est également avantageux que le fluide de réglage de température soit un gaz qui est le même que le gaz sec de dégivrage et qu'avant de parvenir au bloc de réfrigération, le gaz traverse le bloc de séchage.

L'invention sera mieux comprise à la lecture de la description détaillée qui suit de modes de réalisation préférés donnés uniquement à titre illustratif. Dans cette description, on se réfère aux dessins annexés sur lesquels :

    - la fig. 1 est une vue simplifiée en perspective d'un dispositif conforme à l'invention ;

    - la fig. 2 est une vue en coupe diamétrale selon la ligne II-II de la fig. 1 ;

    - la fig. 3 est une vue en coupe selon la ligne III-III du plateau du dispositif de la figure 2 ;

    - la fig. 4 est une vue de dessus du corps du dispositif des fig. 1 et 2 ; et

    - la fig. 5 est une vue schématique d'un appareillage de test de plaques à circuits semi-conducteurs incorporant un dispositif conforme aux fig. 1 à 4.

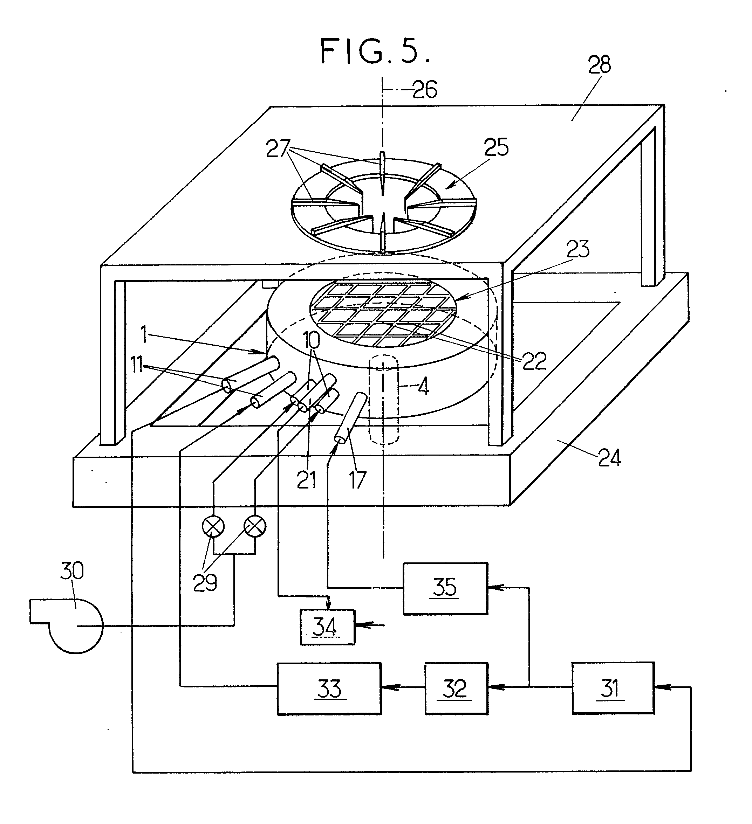

Le dispositif qui va maintenant être décrit de façon détaillée est essentiellement destiné à supporter des plaques primaires (ou "wafers") en matériau semi-conducteur (silicium) et contenant une pluralité de circuits intégrés afin que ceux-ci puissent, avant découpage des circuits individuels, subir des tests de fonctionnement dans des conditions de températures variables (comme cela sera décrit plus particulièrement plus loin, en référence à la fig. 5). Mais il est entendu que le dispositif de l'invention n'est pas limité à cette seule application.

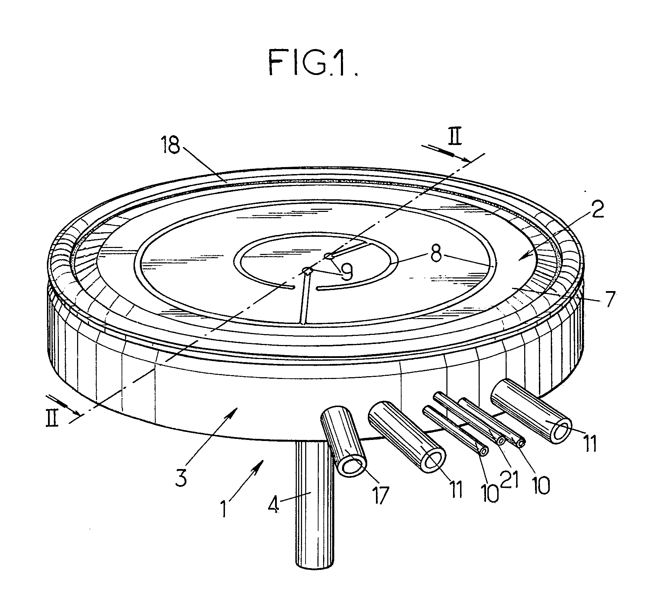

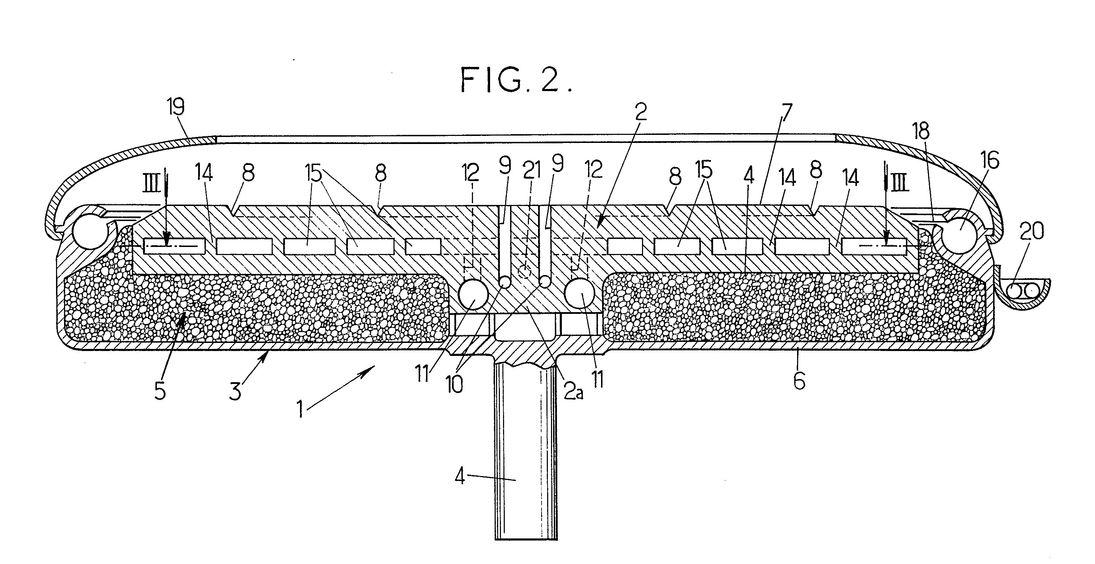

En se reportant tout d'abord essentiellement aux figures 1 et 2, le dispositif de l'invention, désigné dans son ensemble par la référence 1, comporte un plateau circulaire 2 constitué en un matériau thermiquement et électriquement très bon conducteur. Par exemple, le plateau est en cuivre, en un alliage de cuivre ou en aluminium, massif et usiné dans la masse.

Le plateau 2 est supporté, par l'intermédiaire de cales (non visibles sur les dessins) -constituées en un matériau thermiquement et électriquement isolant- de faible section de contact, dans un carter 3 métallique (par exemple en aluminium ou un alliage de ce métal). Le carter 3 présente la forme générale d'une cuve cylindrique de révolution et possède un axe de support 4, situé en position axiale sous son fond. Le plateau 2 est également coaxial à cet axe 4. Le plateau 2 et le carter 3 n'ont aucun point de contact et l'espace libre entre eux est rempli par injection d'un matériau isolant thermiquement et électriquement 5, tel qu'une mousse polyuréthane ou une mousse silicone.

Le positionnement du plateau 2 dans le carter est effectué de manière telle et avec une précision telle que la face inférieure 6 du carter et la face supérieure 7 du plateau soient mutuellement parallèles. La face inférieure 6 du carter peut alors être rectifiée pour servir de face de référence de positionnement vertical de la pièce supportée par le plateau 2 (par exemple dans le cas de l'appareillage de la fig. 5).

Toujours pour ce qui concerne le plateau 2, on notera qu'il présente sur sa face inférieure une partie 2a, saillant vers le bas et s'étendant sensiblement diamétralement, dans laquelle sont creusés différents conduits de liaison dont il sera question plus loin. A leurs extrémités respectives ces conduits sont connectés à des raccords de liaison qui traversent la paroi latérale du carter 3 et qui apparaissent à l'extérieur de celle-ci comme visible sur la fig. 1. Pour simplifier, ces raccords sont désignés par les mêmes références numériques que les conduits proprement dits.

La face supérieure 7 du plateau peut être revêtue d'or pour empêcher l'oxydation du cuivre et améliorer la conduction thermique et électrique. Au moins pour certaines applications, le plateau 2 est raccordé électriquement à un potentiel électrique approprié, en particulier à la masse électrique.

Dans la surface supérieure 7 du plateau 2 sont creusées plusieurs gorges 8 circulaires ou quasi-circulaires, concentriques ; ces gorges sont raccordées par des tronçons de gorges radiales ou sensiblement radiales à des conduits verticaux 9 situés vers le centre et traversant le plateau 2 et se raccordant à des conduits respectifs horizontaux 10, parallèles et situés à proximité l'un de l'autre, s'étendant pratiquement radialement et débouchant sur la face latérale cylindrique du carter 3. Les conduits 10 sont destinés à être raccordés à une source d'air sous une pression inférieure à la pression atmosphérique de telle manière qu'une pièce à traiter, reposant par une de ses faces planes sur la surface 7 du plateau 6, recouvre entièrement au moins la gorge 8 centrale et soit maintenue plaquée sur la surface 7 en raison de la dépression règnant dans cette gorge. Les différentes gorges circulaires 8 sont raccordées à des conduits d'alimentation 10 distincts et commandables de façon indépendante de manière que chaque gorge 8 puisse être utilisée seule, indépendamment des autres gorges. Il est ainsi possible de positionner et de maintenir en place des pièces de dimensions diverses (par exemple des plaques semi-conductrices de diamètres compris entre 75 et 150 mm).

Pour permettre la réalisation de test dans des conditions de températures variables, aussi bien négatives que positives (par exemple entre -65°C et +210°C), il est prévu que l'échange thermique approprié soit réalisé avec la pièce à traiter par conduction thermique directe entre le plateau 2 et la pièce. Pour obtenir une température homogène dans l'ensemble du plateau 2 de façon rapide, on prévoit d'utiliser un courant de fluide (de préférence mais non obligatoirement, un gaz) à température appropriée en tant que vecteur thermique. Pour ce faire, il est donc nécessaire que le courant de gaz soit mis en circulation en restant en contact direct avec le matériau constitutif du plateau 2. A cet effet, le plateau 2 est agencé de la manière suivante.

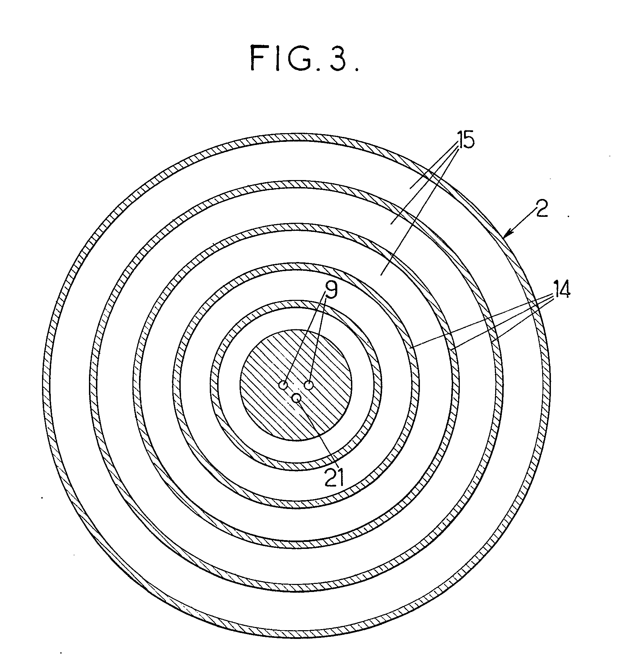

Deux conduits 11 de raccordement à une source de fluide à la température négative ou positive souhaitée sont prévus dans la partie 2a du plateau 2, sur toute la longueur de celle-ci, au voisinage des conduits 10 précités et parallèlement à ceux-ci. En outre, dans la masse du plateau 2 et au-dessus des conduits 11 sont prévues plusieurs enceintes annulaires 15 concentriques délimitées par des cloisons 14 (voir aussi fig. 3). Les cloisons 14 ont un écartement mutuel croissant depuis le centre vers la périphérie de manière que les enceintes annulaires 15 possèdent des sections croissantes afin de compenser les pertes de charge dans l'écoulement du fluide de régulation thermique. Des passages verticaux 12 sont prévus entre les conduits 11 et les enceintes annulaires 15 de manière à créer dans celles-ci une circulation de fluide.

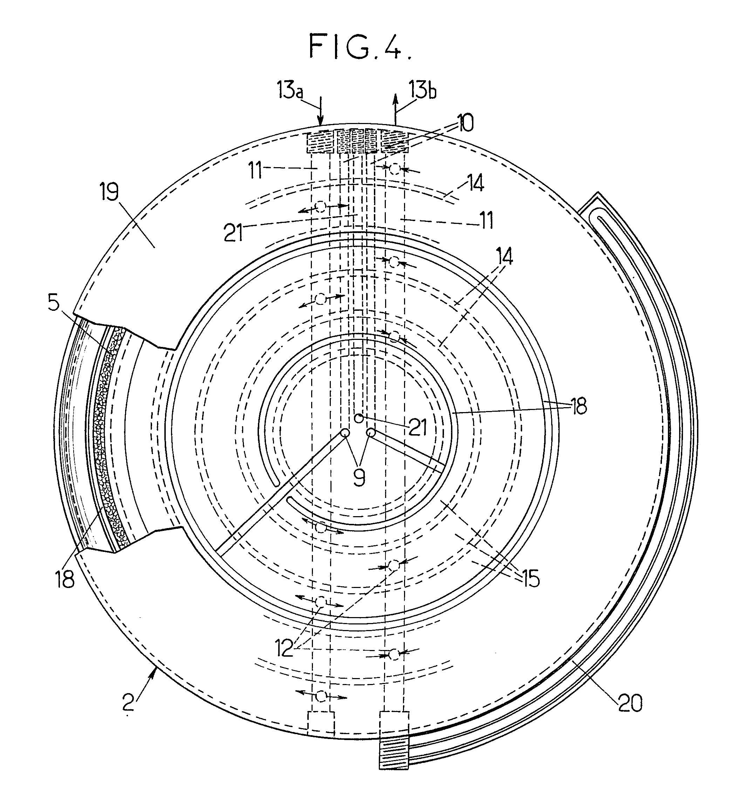

En outre, pour homogénéiser au mieux et au plus vite l'équilibre thermique du matériau constitutif du plateau 2, il a été trouvé avantageux que les circulations du fluide dans deux enceintes annulaires 15 contiguës s'effectuent dans des sens opposés et à partir de points approximativement diamétralement opposés. A cet effet, comme représenté à la fig. 4, le conduit d'amenée du fluide -par exemple conduit de gauche sur la fig. 4 (flèche 13a)- est raccordé aux enceintes annulaires successives par des passages 12 situés alternativement au plus loins et au plus près de son embouchure ; de même, le conduit d'évacuation du fluide -par exemple conduit de droite sur la fig. 4 (flèche 13b)- est raccordé aux enceintes annulaires successives par des passages 12 alternativement respectivement au plus près et au plus loin de son embouchure. Ainsi, dans chaque enceinte, le fluide issu du conduit 11 d'amenée se scinde en deux courants parcourant les deux demi-longueurs curvilignes de l'enceinte avant de s'échapper dans le conduit d'évacuation en un point approximativement diamétralement opposé au point d'injection.

Pour que la fabrication du plateau 2 soit rendue possible de façon pratique, on peut prévoir qu'il soit constitué par deux pièces, savoir une portion supérieure comprenant la semelle supérieure (avec la surface supérieure 7) munie de jupes annulaires concentriques destinées à former les cloisons 14 et une portion inférieure comprenant la semelle inférieure avec la partie saillante 2a précitée ; les portions supérieure et inférieure sont ensuite solidarisées l'une à l'autre par soudure des chants des jupes de la portion supérieure sur la face en regard de la semelle de la portion inférieure.

Sur toute la périphérie du carter 3 s'étend une chambre annulaire 16 raccordée à un conduit d'amenée de gaz 17 situé au voisinage immédiat des conduits 10 et 11 déjà cités. La paroi radialement interne délimitant ces chambres annulaires 16 est percée d'une multiplicité de passages 18 répartis circonférentiellement, dirigés radialement vers l'intérieur ou bien est munie d'une ouverture continue 18 tournée vers l'intérieur (comme représenté sur les figures) ; ces passages ou ouvertures 18 sont légèrement inclinés vers le haut et débouchent sensiblement à hauteur de la surface supérieure 7 du plateau 2 ; cette surface peut du reste être chanfreinée sur tout son pourtour pour ne pas gêner le passage du gaz.

Le gaz amené dans la chambre annulaire 16 est un gaz sous pression, très sec, qui est projeté, par les passages 18, sur la pièce à traiter disposée sur le plateau 2, afin d'empêcher sur cette pièce la formation de condensation et le givrage de celle-ci dans des conditions de températures négatives.

De plus un capot 19, muni d'une ouverture centrale, peut être fixé sur le carter 3 pour coiffer le plateau 2 et servir de déflecteur rabattant le gaz sec vers la pièce située sur la surface 7.

Il est encore possible d'améliorer l'absence de condensation sur la pièce en prévoyant, à proximité immédiate, une zone très froide (ou très chaude). A cet effet, on prévoit, sur une portion circonférentielle de la paroi externe du carter 2, un échangeur thermique 20 par exemple constitué par un tube, en un matériau très bon conducteur thermique dans lequel circule un fluide à très basse (ou très haute) température qui attire l'humidité de l'atmosphère environnante (voir fig. 2 et 4).

Enfin, une sonde de température (non visible sur les figures) peut être prévue immédiatement sous la surface 7 du plateau 2, au centre de celui-ci, et les fils de cette sonde sont situés dans un conduit 21 creusé dans le plateau 2 au voisinage des conduits 10 précités et parallèlement à ceux-ci (voir notamment fig. 2 et 4).

La figure 5 montre un exemple de mise en oeuvre du dispositif 1 conforme à l'invention dans une machine ou appareillage destinée au test de circuits semi-conducteurs 22 présents dans des plaques semi-conductrices ("wafers") 23. Le dispositif 1 est supporté, par son axe 4, par une table 24 par rapport à laquelle il peut pivoter autour de l'axe 4 et être déplacé linéairement selon trois directions mutuellement orthogonales. De la sorte, chaque puce de circuit semi-conducteur 22 peut être amenée dans l'axe 26 d'une tête 25 supportant des contacts 27 d'un appareil de test ; cette tête 25 est supportée de façon fixe par un support 28 solidaire de la table 24.

Du fait des dimensions très réduites des puces 22 et des contacts 27 de la tête 25, il est nécessaire que le positionnement du dispositif 1 sous la tête 25 soit d'une précision extrême et que, par conséquent, aucune gêne ne soit apportée aux mouvements du dispositif. Pour cette raison, les différents conduits 10, 11, 17, 21 sont raccordés aux appareils extérieurs par des conduits de très grande souplesse qui n'opposent pas de couple résistant notable au mouvement du dispositif 1.

Les conduits 10, alimentant chacun une gorge à dépression 8, sont raccordés par l'intermédiaire d'organes de commande respectifs 29, à une pompe à vide 30 fournissant de l'air sous une pression inférieure à la pression atmosphérique.

Les différents fluides utilisés par ailleurs sont en principe de l'air comprimé séché dans un sécheur d'air 31, puis refroidit dans un refroidisseur 32 jusqu'à la température minimale de fonctionnement de la machine (par exemple -65°C). Cet air est ensuite réchauffé dans un dispositif de chauffage 33, jusqu'à une température de fonctionnement réglable dans une plage souhaitée (par exemple -65°C à +210°C) sous l'action de moyens de commande 34 à action manuelle ou automatique recevant en outre les informations en provenance de la sonde thermique 21 du dispositif 1. Cet air à la température requise est ensuite appliqué à l'entrée 11 du dispositif 1 ; la sortie 11 est de préférence raccordée au sécheur 31 ou à la source d'air sous pression de manière à réduire les pertes thermiques.

La sortie du sécheur 31 est également raccordée à l'entrée 17 reliée à la chambre annulaire 16 pour alimenter celle-ci en air sec sous pression.Eventuellement, si l'on souhaite en outre éviter les problèmes dûs à l'électricité statique, il est possible de prévoir un dispositif d'ionisation de l'air 35 disposé en amont de l'entrée 17 qui est en mesure d'ioniser l'air de façon appropriée.

Dans un exemple typique, une machine équipée d'un dispositif conforme à l'invention permet de tester des plaques semi-conductrices ayant des diamètres compris entre 75 et 150 mm, sous des températures comprises entre -65°C et +210°C, avec une précision de ± 1°C sur la température ; la stabilité de la température de la plaque semi-conductrice au cours des tests est de ± 0,5°C et la répétabilité de la température de cette plaque est de ± 0,5°C.

Comme il va de soi et comme il résulte d'ailleurs déjà de ce qui précède, l'invention ne se limite nullement à ceux de ses modes d'application et de réalisation qui ont été plus particulièrement envisagés ; elle en embrasse, au contraire, toutes les variantes.

**Revendications**

1. Dispositif (1) pour, par simple contact, supporter et maintenir en position une pièce et porter celle-ci à une température souhaitée négative ou positive, le maintien de la pièce s'effectuant par effet de dépression, caractérisé en ce qu'il comprend :
- un plateau (2) en un matériau thermiquement bon conducteur et présentant une face supérieure (7) apte à recevoir la pièce précitée, cette face possédant au moins une gorge (8) en communication avec un conduit (9, 10) de raccordement avec une source de gaz en dépression,
- un ensemble d'enceintes (15) prévues dans le plateau (2) et approximativement parallèles les unes aux autres, ces enceintes étant agencées pour être traversées respectivement par des flux de fluide de réglage thermique à la susdite température souhaitée positive ou négative et étant en communication avec des conduits (11) d'arrivée et de sortie de fluide raccordés à une source de fluide de réglage thermique,
- et une chambre périphérique (16) entourant le plateau (2) et contenant un gaz sec sous pression, ladite chambre périphérique comportant un conduit de raccordement (17) à une source d'air sec sous pression et des moyens de sortie (18) répartis sur le pourtour du plateau, débouchant au niveau du plateau et orientés vers le centre du plateau de manière que le gaz sec soit dirigé au-dessus de la surface du plateau et sur la pièce supportée par celui-ci afin d'empêcher la formation de condensation et de givre pour des températures basses.

2. Dispositif selon la revendication 1, caractérisé en ce que les enceintes (15) sont fermées sur elles-mêmes, concentriques et alimentées en parallèles.

3. Dispositif selon la revendication 2, caractérisé en ce que des conduits (11) d'arrivée et de sortie du fluide de réglage thermique s'étendent sous les enceintes (15) et communiquent par des passages respectifs (12) avec lesdites enceintes (15).

4. Dispositif selon la revendication 3, caractérisé en ce que les conduits (11) d'arrivée et de sortie du fluide de règlage thermique sont raccordés aux enceintes annulaires (15) de manière telle que ce fluide circule dans des sens opposés dans deux enceintes (15) contiguës.

5. Dispositif selon l'une quelconque des revendications 2 à 4, caractérisé en ce que les enceintes (15) possèdent des sections transversales différentes et croissantes en fonction de leur éloignement du centre du plateau (2).

6. Dispositif selon l'une quelconque des revendications 1 à 5, caractérisé en ce que le plateau (2) est en un matériau électriquement bon conducteur et est raccordé à une masse électrique.

7. Dispositif selon la revendication 6, caractérisé en ce que le plateau (2) est massif en cuivre, en un alliage de cuivre, ou en aluminium.

8. Dispositif selon la revendication 6 ou 7, caractérisé en ce que la face supérieure (7) du plateau (2) est munie d'un revêtement en or.

9. Dispositif selon l'une quelconque des revendications 1 à 8, caractérisé en ce que la face supérieure (7) du plateau (2) est munie de plusieurs gorges (8) s'étendant respectivement selon des contours fermés ou presque fermés et raccordées indépendamment les unes des autres à une source de fluide.

10. Dispositif selon l'une quelconque des revendications 1 à 9, caractérisé en ce que le plateau (2) est de forme générale ronde, en ce que les gorges (8) s'étendent selon des contours circulaires fermés ou presque fermés sensiblement concentriques et en ce que les enceintes (15) sont annulaires et concentriques.

11. Dispositif selon l'une quelconque des revendications 1 à 10, caractérisé en ce que les divers conduits précités (10, 11, 17) sont creusés au sein du plateau (2) et sont regroupés au voisinage les uns des autres.

12. Dispositif selon l'une quelconque des revendications 1 à 11, caractérisé en ce qu'il comprend un carter (3) en forme de cuvette supportant le plateau (2), en ce que des moyens de support et de positionnement en un matériau thermiquement et électriquement isolant sont interposés, entre le carter et le plateau de manière qu'il n'y ait pas de contact entre le carter et le plateau, et en ce que la chambre périphérique (16) est supportée par le carter (3).

13. Dispositif selon l'une quelconque des revendications 1 à 12, caractérisé en ce qu'il comporte un couvercle annulaire évidé centralement qui coiffe le plateau et qui est configuré pour contribuer à diriger le gaz sec sous pression vers la surface supérieure (7) du plateau (2).

14. Dispositif selon la revendication 12 ou 13, caractérisé en ce que la face inférieure (6) du carter (3) est rectifiée de manière telle qu'elle puisse constituer une référence de positionnement vertical de la surface supérieure (7) du plateau (2).

15. Dispositif selon l'une quelconque des revendications 1 à 14, caractérisé en ce qu'il comporte, en au moins une zone de sa périphérie, un échangeur thermique (20) parcouru par un fluide froid ou chaud et constituant un capteur de l'humidité contenue dans l'air avoisinant le plateau (2).

16. Appareillage ou machine pour le test de plaques de circuits semi-conducteurs, caractérisé en ce qu'il inclut un dispositif (1) selon l'une quelconque des revendications 1 à 15.

17. Appareillage selon la revendication 16, caractérisé en ce que le dispositif (1) est monté à pivotement autour d'un axe central (4) et est mobile selon trois axes de déplacement mutuellement orthogonaux de manière que chaque circuit semi-conducteur (22) de la plaque (23) puisse être amené sous une tête de contact (25) fixe.

18. Appareillage selon la revendication 16 ou 17, caractérisé en ce qu'il comporte une unité de fourniture de fluide de réglage de température porté à une température souhaitée, cette unité comportant un bloc (32) de réfrigération de fluide abaissant la température du fluide à la température minimale de fonctionnement de l'appareillage, puis un bloc (33) de réchauffement de fluide agencé pour réchauffer le fluide jusqu'à une température présélectionnable.

19. Appareillage selon la revendication 18, caractérisé en ce que la température est sélectionnable entre -65°C et +210°C.

20. Appareillage selon l'une quelconque des revendications 16 à 19, caractérisé en ce qu'il comporte en outre une unité de fourniture d'un gaz sec incluant un bloc de séchage de gaz (31).

21. Appareillage selon la revendication 20, caractérisé en ce qu'en aval du bloc de séchage de gaz est prévu un bloc (35) d'ionisation du gaz sec.

22. Appareillage selon les revendications 18 à 20, caractérisé en ce que le fluide de réglage de température est un gaz qui est le même que le gaz sec de dégivrage et en ce qu'avant de parvenir au bloc de réfrigération, le gaz traverse le bloc de séchage (31).

EP 0 341 156 A1

# FIG.1.

FIG. 2.

# FIG.3.

# FIG.4.

# FIG.5.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4 ) |
|---|---|---|---|
| A | US-A-4609037 (TENCOR)<br>* abrégé *<br><br>* colonne 3, ligne 18 – colonne 4, ligne 12; figures 1-3 *<br>--- | 1, 3, 4, 6, 7, 10, 16 | H01L21/00<br>G01R1/04 |
| A,D | US-A-4491173 (TEMPTRONIC)<br>* abrégé *<br><br>* colonne 4, ligne 5 – ligne 35; figure 1 *<br>--- | 1, 6, 7, 10, 16, 17 | |
| A | US-A-4131267 (DISCO)<br>* abrégé; figures 2, 3 *<br><br>----- | 1, 6, 7, 9, 10, 16 | |

| DOMAINES TECHNIQUES RECHERCHES (Int. Cl.4 ) |
|---|
| H01L<br>G01R |

Le présent rapport a été établi pour toutes les revendications

| Lieu de la recherche | Date d'achèvement de la recherche | Examinateur |
|---|---|---|
| LA HAYE | 23 JUIN 1989 | LOMMEL A. |

EPO FORM 1503 03.82 (P0402)